# FASCICULE DE BREVET EUROPEEN

(11) **EP 3 503 192 B1**
(45) Date de publication et mention de la délivrance du brevet: **09.02.2022**
(21) Numéro de dépôt: 18208212.3
(22) Date de dépôt: 26.11.2018
(51) Int. Cl.: H01L 27/146, H04N 5/33, H04N 13/00

(54) **DISPOSITIF D'ACQUISITION D'UNE IMAGE 2D ET D'UNE IMAGE DE PROFONDEUR D'UNE SCÈNE**
BILDERFASSUNGSVORRICHTUNG FÜR EIN 2D-BILD UND EIN TIEFENBILD EINER SZENE
DEVICE FOR ACQUIRING A 2D IMAGE AND A DEPTH IMAGE OF A SCENE

(30) Priorité: 19.12.2017 FR 1762469
(43) Date de publication de la demande: 26.06.2019
(73) Titulaire: Commissariat à l'Energie Atomique et aux Energies Alternatives, 75015 Paris (FR)
(72) Inventeur: VAILLANT, Jérôme, 38000 GRENOBLE (FR); CAZAUX, Yvon, 38100 GRENOBLE (FR); ROCHAS, Alexis, 38500 COUBLEVIE (FR)
(74) Mandataire: Cabinet Beaumont

(56) Documents cités:
- US-A1- 2013 234 029
- US-A1- 2014 015 932
- US-A1- 2015 054 962
- US-A1- 2016 181 226
- US-A1- 2017 278 826
- US-B1- 9 818 791

## Description

### Domaine

La présente demande concerne le domaine des dispositifs d'acquisition d'images, et, plus particulièrement, des dispositifs d'acquisition d'images adaptés à acquérir une image 2D et une image de profondeur d'une scène.

### Exposé de l'art antérieur

Des dispositifs d'acquisition d'images aptes à acquérir des informations de profondeur ont été proposés. Par exemple, des détecteurs de temps de vol (ToF) agissent pour émettre un signal lumineux vers une scène, puis pour détecter le signal lumineux en retour réfléchi par des objets de la scène. Par le calcul du temps de vol du signal lumineux, on peut estimer la distance au dispositif d'acquisition d'objets de la scène. A titre d'exemple, les pixels d'un tel capteur peuvent utiliser des photodiodes de type SPAD (diode à avalanche à photon unique).

Dans certaines applications, il serait souhaitable de pouvoir capter à la fois une image 2D d'une scène et une image de profondeur correspondante de la scène.

Alors qu'une solution pour atteindre cet objectif serait d'utiliser des capteurs d'images séparés pour capter l'image 2D et l'image de profondeur, une telle solution n'est pas optimale en raison du fait que ces capteurs auront des points de vue différents de la scène, ce qui conduit à un défaut d'alignement entre les pixels des images correspondantes. En outre, l'utilisation de deux capteurs augmenterait l'encombrement et le coût du dispositif.

Une autre solution serait d'intégrer les pixels de l'image 2D et les pixels de profondeur dans un même réseau de détecteurs. Toutefois, un problème est que les pixels de profondeur ont généralement des dimensions notablement plus grandes que les pixels d'image 2D et/ou des tensions d'alimentation notablement plus élevées que les pixels d'image 2D, ce qui rend une telle intégration complexe.

Il serait souhaitable de pouvoir disposer d'un dispositif d'acquisition d'une image 2D et d'une image de profondeur d'une scène, ce dispositif palliant au moins partiellement un ou plusieurs des inconvénients des dispositifs connus. Les documents US 2017/278826, US 2015/054962, US 2014/015932 et US 9818791 décrivent des dispositifs d'acquisition d'une image 2D et d'une image de profondeur connus de l'art antérieur.

### Résumé

Ainsi, l'invention prévoit un dispositif d'acquisition d'une image 2D et d'une image de profondeur, comme défini dans la revendication 1.

Selon un mode de réalisation, chaque pixel de profondeur comprend une photodiode de type SPAD.

Selon un mode de réalisation, chaque pixel de profondeur comprend plusieurs zones mémoire couplées à une même zone de détection, et permet de mesurer un déphasage entre un signal lumineux modulé en amplitude, émis par une source lumineuse du dispositif, et un signal lumineux reçu par la zone de photodétection du pixel, après réflexion sur une scène dont on souhaite acquérir une image.

Selon un mode de réalisation, le deuxième capteur comprend un empilement d'interconnexion dans lequel sont formées des pistes et/ou bornes de connexion électrique connectant les pixels de profondeur du deuxième capteur à un circuit périphérique de commande et d'alimentation du deuxième capteur, ledit empilement d'interconnexion étant disposé du côté de la face arrière du deuxième substrat semiconducteur.

Selon un mode de réalisation, le premier capteur comprend un empilement d'interconnexion dans lequel sont formées des pistes et/ou bornes de connexion électrique connectant les pixels d'image 2D du premier capteur à un circuit périphérique de commande et d'alimentation du premier capteur, ledit empilement d'interconnexion étant disposé du côté de la face arrière du premier substrat semiconducteur.

Selon un mode de réalisation, l'empilement d'interconnexion du premier capteur ne comprend pas de métallisations dans les fenêtres transmissives du premier capteur.

Selon un mode de réalisation, chaque pixel d'image 2D du premier capteur comprend une photodiode.

Selon un mode de réalisation, le premier substrat semiconducteur ne comprend pas de régions implantées localisées dans les fenêtres transmissives du premier capteur.

Selon un mode de réalisation, dans chaque pixel de profondeur du deuxième capteur, une zone de photodétection du pixel est entourée par un mur d'isolation vertical s'étendant sur toute l'épaisseur du deuxième substrat.

Selon un mode de réalisation, en vue de dessus, la surface de chaque pixel de profondeur entourée par le mur d'isolation vertical est supérieure à la surface de la fenêtre transmissive correspondante du premier capteur.

Selon un mode de réalisation, chaque fenêtre transmissive du premier capteur comprend un filtre optique passe-bande adapté à transmettre la lumière uniquement dans une bande de largeur à mi-hauteur inférieure à 30 nm.

Selon un mode de réalisation, chaque fenêtre transmissive du premier capteur comprend une microlentille disposée entre la face arrière du premier substrat semiconducteur et le deuxième capteur.

Selon un mode de réalisation, le dispositif comporte en outre un circuit de contrôle et de traitement formé dans et sur un troisième substrat semiconducteur, ledit circuit de contrôle et de traitement étant accolé à la face arrière du deuxième capteur.

Selon un mode de réalisation, le circuit de contrôle et de traitement est fixé à la face arrière du deuxième capteur par collage moléculaire hybride.

Selon un mode de réalisation, les premier et deuxième substrats semiconducteurs sont en silicium monocristallin.

Selon un mode de réalisation, les premier et deuxième capteurs sont fixés par collage moléculaire.

Selon un mode de réalisation, les pixels de profondeur sont couplés par blocs de plusieurs pixels voisins de façon à réaliser un photo-multiplieur.

Selon un mode de réalisation, chaque fenêtre transmissive du premier capteur comprend un pixel actif, par exemple un pixel infrarouge ou un pixel visible.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe illustrant de façon schématique et partielle un exemple d'un mode de réalisation d'un dispositif d'acquisition d'une image 2D et d'une image de profondeur ;
la figure 2 est une vue en coupe illustrant plus en détail un exemple de réalisation d'un capteur d'image 2D du dispositif de la figure 1 ;
la figure 3 est une vue en coupe illustrant plus en détail un exemple de réalisation d'un capteur d'image de profondeur du dispositif de la figure 1 ; et
la figure 4 est une vue de dessus schématique représentant un exemple d'agencement des pixels 2D et des pixels de profondeur dans le dispositif de la figure 1.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, la réalisation des photodiodes et des circuits de commande des pixels d'image 2D et des pixels de profondeur n'a pas été détaillée, la réalisation de tels pixels étant à la portée de l'homme du métier à partir des indications de la présente description. Dans la description qui suit, lorsque l'on fait référence à des qualificatifs de position absolue, tels que les termes "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des figures, étant entendu que, en pratique, les dispositifs décrits peuvent être orientés différemment. Sauf précision contraire, les expressions "approximativement", "sensiblement", et "de l'ordre de" signifient à 10 % près, de préférence à 5 % près.

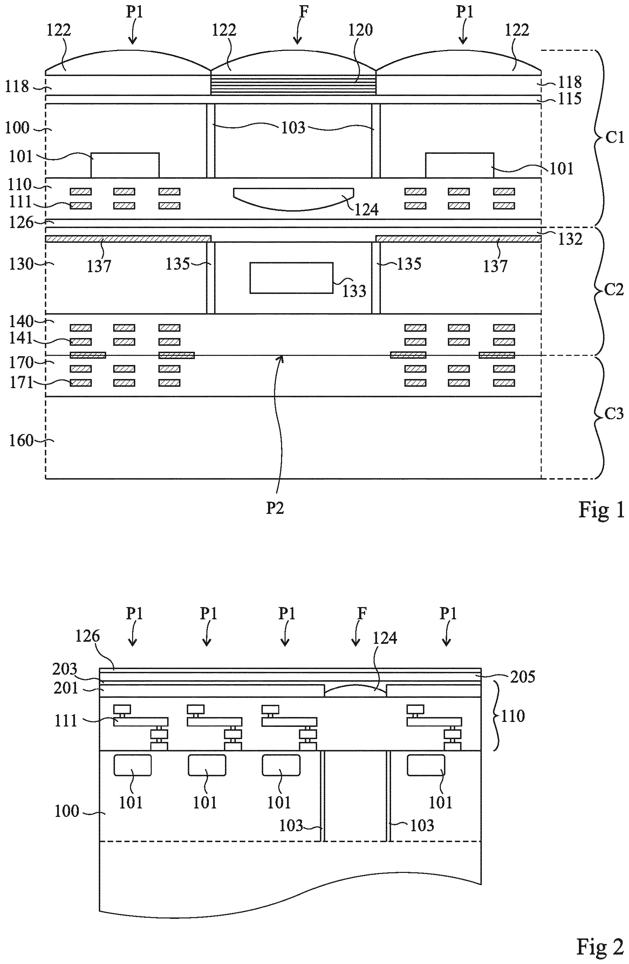

La figure 1 est une vue en coupe illustrant de façon schématique et partielle un exemple d'un mode de réalisation d'un dispositif d'acquisition d'une image 2D et d'une image de profondeur d'une scène.

Le dispositif de la figure 1 comprend :
un premier capteur C1 formé dans et sur un premier substrat semiconducteur 100, par exemple un substrat en silicium monocristallin, le capteur C1 comprenant une pluralité de pixels d'images 2D P1 et une pluralité de fenêtres F répartis sur la surface du capteur ; et
un deuxième capteur C2 formé dans et sur un deuxième substrat semiconducteur 130, par exemple un substrat en silicium monocristallin, le capteur C2 étant accolé à la face arrière du capteur C1 et comprenant une pluralité de pixels de profondeur P2 disposés respectivement en regard des fenêtres F du capteur C1, chaque pixel de profondeur P2 comprenant une photodiode de type SPAD.

On notera que dans la présente description, on entend respectivement par face avant et face arrière d'un élément, la face de l'élément destinée à être tournée vers la scène dont on souhaite acquérir une image, et la face de l'élément opposée à sa face avant. Dans l'exemple de la figure 1, les faces avant et arrière du dispositif d'acquisition sont respectivement sa face supérieure et sa face inférieure.

En pratique, le dispositif de la figure 1 est destiné à être utilisé en combinaison avec une source lumineuse, par exemple une source laser, émettant de la lumière à une longueur d'onde déterminée ou dans une gamme de longueurs d'ondes déterminée, de préférence une gamme de longueurs d'ondes étroite, par exemple une gamme de largeur à mi-hauteur inférieure à 3 nm, par exemple une source de longueur d'onde centrale d'émission de l'ordre de 940 nm, par exemple une source du type mentionné sur la page internet https://www.sony-semicon.co.jp/products_en/laserdiodewld/products/940tof_vcsel.ht ml de la société Sony. A titre d'exemple, la gamme de longueurs d'ondes d'émission de la source lumineuse est située en dehors du domaine visible, par exemple dans le proche infrarouge, par exemple dans la plage de 700 à 1000 µm. En fonctionnement, le signal lumineux produit par la source lumineuse est émis vers la scène (par exemple par l'intermédiaire d'une ou plusieurs lentilles), sous la forme d'impulsions lumineuses, par exemple des impulsions périodiques. Le signal lumineux retour réfléchi par la scène est capté par les pixels de profondeur P2 du capteur C2, de façon à mesurer le temps de vol du signal lumineux en différents points de la scène et en déduire la distance au dispositif d'acquisition en différents points de la scène. Les pixels P1 du capteur C1 sont quant à eux aptes à capter de la lumière visible émise par la scène pour former une image 2D de la scène. Les fenêtres F du capteur C1 sont transmissives dans la gamme d'émission de la source lumineuse de façon à permettre la détection du signal lumineux retour par les pixels de profondeur P2 du capteur C2. A titre d'exemple, le coefficient de transmission des fenêtres F du capteur C1 dans la gamme de longueurs d'ondes d'émission de la source lumineuse est supérieur à 50 %.

Dans l'exemple représenté, chaque pixel P1 du capteur C1 comprend une photodiode 101 comprenant une ou plusieurs régions implantées localisées formées dans le substrat semiconducteur 100. Dans cet exemple, la ou les régions implantées de la photodiode 101 sont disposées du côté de la face arrière du substrat 101. Chaque pixel P1 peut en outre comprendre un ou plusieurs composants supplémentaires (non représentés), par exemple des transistors de contrôle, formés du côté de la face arrière du substrat 100, par exemple dans le substrat 100 et sur la face arrière du substrat 100. Le capteur C1 comprend en outre un empilement d'interconnexion 110, constitué de couches diélectriques et conductrices alternées revêtant la face arrière du substrat 100, dans lequel sont formées des pistes et/ou bornes de connexion électrique 111 connectant les pixels P1 du capteur à un circuit périphérique de commande et d'alimentation, non représenté.

Dans l'exemple représenté, le capteur C1 comprend des murs d'isolation verticaux 103 traversant le substrat 100 sur toute son épaisseur et délimitant les portions de substrat correspondant respectivement aux différentes fenêtres F du capteur C1. Les murs d'isolation verticaux 103 ont notamment une fonction d'isolation optique, et peuvent en outre avoir une fonction d'isolation électrique. A titre d'exemple, les murs d'isolation verticaux 103 sont en un matériau diélectrique, par exemple de l'oxyde de silicium. Des murs d'isolation similaires peuvent en outre être prévus entre les pixels P1 du capteur C1.

Dans l'exemple représenté, le substrat 100 du capteur C1 ne comprend pas de région implantée localisée dans les fenêtres F du capteur C1, de façon à maximiser la transparence du substrat dans les fenêtres F. A titre de variante, dans les fenêtres F, le substrat 100 peut être remplacé par un matériau plus transparent à la longueur d'onde d'émission de la source lumineuse utilisée pour la mesure de distance, par exemple de l'oxyde de silicium.

Par ailleurs, dans cet exemple, l'empilement d'interconnexion 110 du capteur C1 ne comprend pas d'élément métallique mais seulement des couches diélectriques dans les fenêtres F, de façon à maximiser la transparence de l'empilement d'interconnexion dans les fenêtres F. Les modes de réalisation décrits ne se limitent toutefois pas à ce cas particulier. A titre de variante, l'empilement d'interconnexion 110 peut comprendre des éléments conducteurs s'étendant sur une partie de la surface de chaque fenêtre F.

L'épaisseur du substrat 100 est par exemple comprise entre 2 et 10 µm, par exemple entre 3 et 5 µm.

Chaque fenêtre F a par exemple, en vue de dessus, des dimensions sensiblement identiques aux dimensions des pixels P1 du capteur C1. A titre d'exemple, en vue de dessus, la plus grande dimension de chaque pixel P1 ou fenêtre F du capteur C1 est inférieure à 10 µm, par exemple inférieure à 5 µm, par exemple inférieure à 2 µm, par exemple de l'ordre de 1 µm.

Dans l'exemple représenté, la face avant du substrat 100 est revêtue d'une couche de passivation 115, par exemple une couche d'oxyde de silicium, une couche de HfO₂, une couche d'Al₂O₃, ou un empilement de plusieurs couches de matériaux différents pouvant avoir d'autres fonctions que la seule fonction de passivation (antireflet, filtrage, collage, etc.), s'étendant sur sensiblement toute la surface du capteur. A titre d'exemple, la couche 115 est disposée sur et en contact avec la face avant du substrat 100.

Dans l'exemple de la figure 1, le capteur C1 est un capteur d'image 2D couleur, c'est-à-dire qu'il comprend des pixels P1 de différents types, adaptés à mesurer des intensités lumineuses dans des gammes de longueurs d'ondes visibles distinctes. Pour cela, chaque pixel P1 comprend un filtre couleur 118, par exemple une couche de résine colorée, disposé du côté de la face avant du substrat 100, par exemple sur et en contact avec la face avant de la couche de passivation 115, en vis-à-vis de la photodiode 101 du pixel. A titre d'exemple, le capteur C1 comprend trois types de pixels P1, des premiers pixels P1 appelés pixels bleus, comprenant un filtre couleur 118 transmettant préférentiellement de la lumière bleue, des deuxièmes pixels P1 appelés pixels rouges, comprenant un filtre couleur 118 transmettant préférentiellement de la lumière rouge, et des troisièmes pixels appelés pixels verts, comprenant un filtre couleur 118 transmettant préférentiellement de la lumière verte. Sur la figure 1, les différents types de pixels ne sont pas différenciés. A titre de variante, le capteur C1 peut être un capteur d'image 2D monochromatique, auquel cas les filtres 118 peuvent être omis.

Dans l'exemple représenté, chaque fenêtre F du capteur C1 comprend un filtre 120, par exemple un filtre interférentiel, adapté à transmettre la lumière dans la gamme de longueurs d'ondes d'émission de la source lumineuse. De préférence, le filtre 120 est adapté à transmettre la lumière uniquement dans une bande de longueurs d'ondes relativement étroite centrée sur la gamme de longueurs d'ondes d'émission de la source lumineuse du système, par exemple une gamme de longueurs d'ondes de largeur à mi-hauteur inférieure à 30 nm, par exemple inférieure à 20 nm, par exemple inférieure à 10 nm. Dans cet exemple, le filtre 120 est disposé du côté de la face avant du substrat 100, par exemple sur et en contact avec la face avant de la couche de passivation 115, et s'étend sur sensiblement toute la surface de la fenêtre F. Le filtre 120 permet d'éviter des déclenchements indésirables de la photodiode du pixel P2 sous-jacent sous l'effet d'un rayonnement lumineux ne provenant pas de la source lumineuse du système. Dans l'exemple de la figure 1, le filtre 120 est localisé au niveau des seules fenêtres F du capteur, et disposé sur la face supérieure du substrat 100, ce qui permet de limiter la diaphotie ou crosstalk entre les pixels P1 du capteur C1. A titre de variante, le filtre 120 peut être disposé entre les substrats 100 et 130, sur la face inférieure du substrat 100 ou sur la face supérieure du substrat 130, et s'étendre de façon continue sur sensiblement toute la surface du dispositif. Dans ce cas, pour limiter le crosstalk lié à la lumière réfléchie (non transmise et non absorbée) par le filtre 120, un écran métallique formé dans l'empilement d'interconnexion 110 peut être prévu à la périphérie de chaque pixel P1 du capteur C1.

Chaque pixel P1 du capteur C1 peut en outre comprendre une microlentille 122 disposée du côté de la face avant du substrat 100, par exemple sur et en contact avec le filtre couleur 118 du pixel, adaptée à focaliser la lumière incidente sur la photodiode 101 du pixel.

De plus, chaque fenêtre F du capteur C1 peut comprendre une microlentille externe 122, par exemple similaire ou identique aux microlentilles 122 des pixels P1, disposée du côté de la face avant du substrat 100, par exemple sur et en contact avec le filtre 120 de la fenêtre.

Chaque fenêtre F peut en outre comprendre une microlentille interne 124 formée dans l'empilement d'interconnexion 110 du capteur et permettant, en coopération avec la microlentille 122 de la fenêtre, de focaliser la lumière incidente sur la photodiode du pixel P2 sous-jacent.

Dans l'exemple représenté, la face arrière du capteur C1 est collée à la face avant du capteur C2 par collage moléculaire. Pour cela, le capteur C1 comprend une couche 126, par exemple en oxyde de silicium, revêtant sa face arrière. De plus, le capteur C2 comprend une couche 132 de même nature que la couche 126, par exemple en oxyde de silicium, revêtant sa face avant. La face arrière de la couche 126 est mise en contact avec la face avant de la couche 132 de façon à réaliser un collage moléculaire du capteur C2 au capteur C1. A titre d'exemple, la couche 126, respectivement 132, s'étend de façon continue sur toute la surface du capteur C1, respectivement C2.

Chaque pixel P2 du capteur C2 comprend une photodiode de type SPAD 133 formée dans le substrat 130, en vis-à-vis de la fenêtre F correspondante du capteur C1. La photodiode 133 comprend une ou plusieurs régions semiconductrices localisées formées dans le substrat semiconducteur 130. Chaque pixel P2 peut en outre comprendre un ou plusieurs composants supplémentaires (non représentés), par exemple des transistors de contrôle, formés du côté de la face arrière du substrat 130, par exemple dans le substrat 130 et sur la face arrière du substrat 130. Le capteur C2 comprend en outre un empilement d'interconnexion 140, constitué de couches diélectriques et conductrices alternées revêtant la face arrière du substrat 130, dans lequel sont formées des pistes et/ou bornes de connexion électrique 141 connectant les pixels P2 du capteur à un circuit périphérique de commande et d'alimentation, non représenté.

Par photodiode de type SPAD, on entend ici une photodiode constituée par une jonction PN polarisée en inverse à une tension supérieure à son seuil d'avalanche. Lorsqu'aucune charge électrique n'est présente dans la zone de déplétion ou zone de charge d'espace de la jonction PN, la photodiode est dans un état pseudo-stable, non conducteur. Lorsqu'une charge électrique photogénérée est injectée dans la zone de déplétion, si la vitesse de déplacement de cette charge dans la zone de déplétion est suffisamment élevée, c'est-à-dire si le champ électrique dans la zone de déplétion est suffisamment intense, la photodiode est susceptible d'entrer en avalanche. Un seul photon est ainsi capable de générer un signal électrique mesurable, et ce avec un temps de réponse très court, ce qui est tout particulièrement adapté aux mesures de temps de vol que l'on cherche à réaliser. La plupart des structures connues de photodiodes SPAD peuvent être utilisées dans le capteur C2 de la figure 1, par exemple des structures à jonction PN planaire surfacique, des structures à jonction PN planaire enterrée, ou encore des structures à jonction PN verticale, par exemple telles que décrites dans la demande de brevet français N°16/58513 déposée le 13 septembre 2016 et dans la demande de brevet PCT correspondante N°PCT/FR2017/052406 déposée le 11 septembre 2017 (B15154/DD17140). La prévision de photodiodes SPAD à jonctions PN verticales, par exemple telles que décrites dans les demandes de brevet français et PCT susmentionnées, permet avantageusement de limiter la surface active de détection des pixels P2. Ceci permet que les dimensions, en vue de dessus, des pixels P2, et par conséquent des fenêtres F, soient relativement faibles, par exemple du même ordre que les dimensions des pixels P1, et ainsi de limiter la perte de résolution dans l'image 2D résultant de la présence des fenêtres F.

Dans l'exemple représenté, dans chaque pixel P2 du capteur C2, la photodiode 133 du pixel est entièrement entourée par un mur d'isolation vertical 135 traversant le substrat 130 sur toute son épaisseur. Le mur 135 a notamment une fonction d'isolation optique, et peut en outre avoir une fonction d'isolation électrique. A titre d'exemple, le mur d'isolation vertical 135 est en un matériau diélectrique, par exemple de l'oxyde de silicium. A titre de variante, le mur d'isolation vertical 135 est un mur multicouche comprenant une couche intérieure en un matériau diélectrique, par exemple de l'oxyde de silicium, une ou plusieurs couches intermédiaires comprenant au moins une couche métallique, et une couche extérieure en un matériau diélectrique, par exemple de l'oxyde de silicium. Le mur d'isolation vertical 135 est par exemple situé sensiblement à l'aplomb du mur d'isolation vertical 103 entourant la portion de substrat 100 de la fenêtre F correspondante du capteur C1. Les murs 103 et 135 permettent notamment de limiter le risque que des rayons lumineux reçus par un pixel P1 voisin de la fenêtre F ne viennent activer la photodiode SPAD du pixel P2 correspondant, ce qui pourrait conduire à une mesure de profondeur erronée. Dans une variante de réalisation, la zone de détection du pixel P2 (et donc le mur périphérique 135 du pixel) a, en vue de dessus, une surface supérieure à la surface de la fenêtre F correspondante du capteur C1. Ceci permet de faciliter l'alignement de la fenêtre F au-dessus du pixel P2 lors de l'assemblage des capteurs C1 et C2.

On notera qu'une photodiode de type SPAD est généralement associée à des circuits annexes, notamment un circuit de polarisation de sa jonction PN à une tension supérieure à son seuil d'avalanche, un circuit de lecture adapté à détecter un déclenchement d'une avalanche de la photodiode, ainsi qu'un circuit d'extinction ("quenching circuit" en anglais) ayant pour fonction d'interrompre l'avalanche de la photodiode une fois celle-ci déclenchée. Ces circuits annexes n'ont pas été représentés sur les figures et ne seront pas détaillés, les modes de réalisation décrits étant compatibles avec les circuits annexes équipant les photodiodes SPAD connues. Ces circuits annexes peuvent par exemple être disposés, au moins en partie, dans et sur la face arrière des portions du substrat 130 situées à l'extérieur des murs d'isolation verticaux 135 des pixels.

Dans l'exemple de la figure 1, le capteur C2 comprend en outre un écran métallique 137 revêtant sensiblement toute la face avant du substrat 130, à l'exception des portions de substrat 130 situées à l'intérieur des murs 135 (correspondant aux zones de photodétection des pixels P2). Là encore, la fonction de l'écran métallique 137 est une fonction d'isolation optique, visant à éviter que des rayons lumineux reçus par un pixel P1 voisin de la fenêtre F ne viennent activer la photodiode SPAD du pixel P2 correspondant. A titre de variante, l'écran 137 n'est pas continu mais est constitué d'une pluralité de couronnes disjointes entourant respectivement, en vue de dessus, les zones de photodétection des différents pixels P2 du capteur. Un avantage est que ceci permet de limiter les réflexions parasites de lumière par l'écran 137 en direction des pixels P1 du capteur C1.

Dans cet exemple, la couche d'oxyde de silicium 132 de collage du capteur C2 au capteur C1 est disposée sur et en contact avec la face avant de l'écran métallique 137 en dehors des zones de photodétection des pixels P2, et sur et en contact avec la face avant du substrat 130 dans les zones de photodétection des pixels P2.

L'épaisseur du substrat 130 est par exemple comprise entre 5 et 50 µm, par exemple entre 8 et 20 µm.

On notera que l'agencement des capteurs C1 et C2 du dispositif de la figure 1 est avantageux en ce que l'empilement d'interconnexion 140 du capteur C2 est situé du côté du substrat 130 du capteur opposé au capteur C1. En effet, une difficulté rencontrée lorsque l'on cherche à co-intégrer des pixels à photodiode classique et des pixels à photodiode SPAD est que les niveaux de tension d'alimentation requis par les deux types de pixels sont très différents, ce qui nécessite de prévoir des éléments d'isolation électrique relativement encombrants entre des pixels voisins de types différents. Dans l'exemple de la figure 1, les capteurs C1 et C2 sont naturellement isolés électriquement au niveau de leurs matrices de pixels respectives, ainsi qu'au niveau de leurs circuits de commande/lecture respectifs. Du fait de la disposition de l'empilement d'interconnexion 140 du capteur C2 du côté du substrat 130 opposé au capteur C1, les risques de claquage et/ou de couplage parasite liés à la différence de potentiel entre les pistes conductrices d'alimentation des pixels du capteur C1 et les pistes conductrices d'alimentation des pixels du capteur C2 sont évités. A titre d'exemple, dans le dispositif de la figure 1, la tension d'alimentation des pixels P2 du capteur C2 est au moins cinq fois, voire dix fois supérieure à la tension d'alimentation des pixels P1 du capteur C1.

De façon optionnelle, le dispositif de la figure 1 peut en outre comporter un circuit supplémentaire de contrôle et de traitement C3 formé dans et sur un troisième substrat semiconducteur 160, par exemple un substrat en silicium monocristallin, le circuit C3 étant accolé à la face arrière du capteur C2. Le circuit C3 comprend par exemple, pour chaque pixel de profondeur P2 du capteur, un circuit de datage d'évènement, par exemple un circuit de type TDC ("Time to Digital Converter" - convertisseur temps-numérique), permettant de mesurer le temps de vol du signal lumineux réfléchi capté par le pixel. Dans cet exemple, le circuit C3 comprend des composants formés du côté de la face avant du substrat 160, dans et sur la face avant du substrat 160. Le circuit C3 comprend en outre un empilement d'interconnexion 170, constitué de couches diélectriques et conductrices alternées revêtant la face avant du substrat 160, dans lequel sont formées des pistes et/ou bornes de connexion électrique 171 connectant les composants du circuit C3 à un circuit périphérique de commande et d'alimentation, non représenté.

Dans cet exemple, la face avant de l'empilement d'interconnexion 170 du circuit C3 comprend des plages métalliques de connexion électrique directement connectées à des plages métalliques correspondantes disposées sur la face arrière de l'empilement d'interconnexion 140 du capteur C2. A titre d'exemple, la face arrière du capteur C2 est collée à la face avant du circuit C3 par collage moléculaire hybride métal-métal/oxyde-oxyde.

Le circuit C3 peut en outre être connecté au capteur C1 par des vias conducteurs isolés (non représentés) traversant le capteur C2, situés dans une région périphérique du dispositif (à la périphérie des matrices de pixel des capteurs C1 et C2).

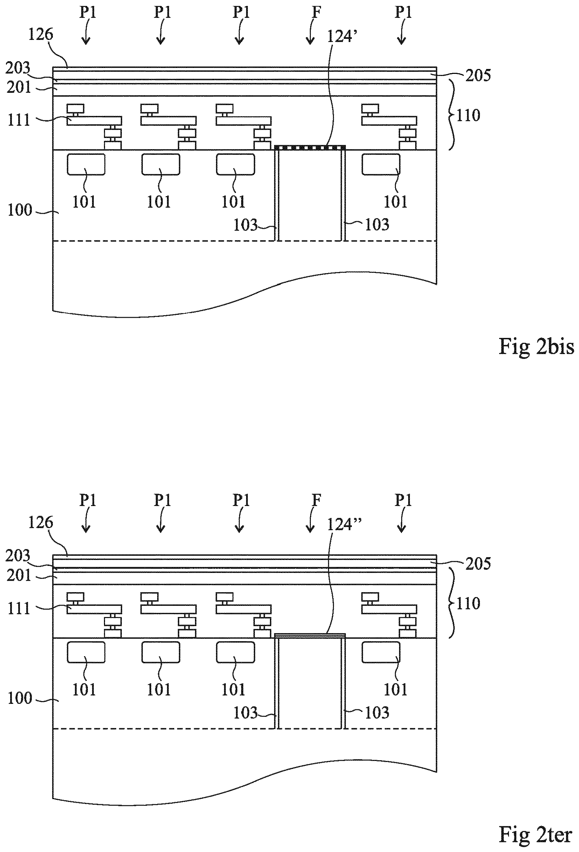

La figure 2 est une vue en coupe illustrant plus en détail un exemple de réalisation du capteur d'image 2D C1 du dispositif de la figure 1.

Pour réaliser ce capteur, on part d'un substrat semiconducteur 100 relativement épais, par exemple de plusieurs centaines de micromètres d'épaisseur.

Les régions implantées des photodiodes 101 et des éventuels composants de contrôle des pixels P1 du capteur sont formés à partir d'une première face du substrat, à savoir sa face supérieure dans l'orientation de la figure 2. Les murs d'isolation verticaux 103 délimitant, en vue de dessus, les fenêtres F du capteur, sont en outre formés depuis la face supérieure du substrat 100.

L'empilement d'interconnexion 110 du capteur C1 est ensuite formé sur la face supérieure du substrat 100. Dans cet exemple, l'empilement d'interconnexion comprend une couche de passivation 201, par exemple en nitrure de silicium. La microlentille 124 de la fenêtre F est formée dans la couche supérieure de passivation 201. Plus particulièrement, pour former la microlentille 124, une structure en résine ayant sensiblement la forme de la lentille que l'on cherche à réaliser est formée sur la face supérieure de la couche 201, puis une gravure localisée en regard de la structure de résine est mise en oeuvre de façon à transférer le motif de la structure de résine dans la couche 201. L'empilement d'interconnexion 110 peut en outre comporter une couche supérieure de planarisation 203 en un matériau d'indice de réfraction différent de celui de la couche 201, par exemple en oxyde de silicium.

Dans l'exemple de la figure 2, la face supérieure de l'empilement d'interconnexion 110 est revêtue par une couche ou un empilement de couches 205, par exemple disposé sur et en contact avec la face supérieure de la couche de planarisation 203, formant un dispositif antireflet pour la longueur d'onde d'émission de la source lumineuse utilisée pour la mesure de distance. La couche 205 peut en outre être prévue pour filtrer les autres longueurs d'ondes, remplissant alors une fonction similaire à celle du filtre 120 de la figure 1. A titre de variante, la fonction de filtrage passe bande à la longueur d'onde de la source lumineuse est réalisée en partie par le filtre 120 et en partie par la couche 205. Ceci permet de relâcher les contraintes de performances de filtrage du filtre 120, et ainsi de réaliser un filtre 120 moins épais.

La couche 126 destinée à assurer le collage moléculaire du capteur C1 au capteur C2 est quant à elle disposée sur et en contact avec la face supérieure de la couche antireflet 205, étant entendu que la couche 126 peut être prise en compte dans le dimensionnement de la couche antireflet 205.

On notera que, dans l'exemple de la figure 2, la microlentille 124 constitue un élément optique apte à favoriser le transfert de la lumière incidente du capteur C1 vers les pixels P2 du capteur C2. A titre de variante, la microlentille 124 peut être remplacée par d'autres éléments optiques aptes à remplir cette fonction.

La figure 2bis illustre une variante de réalisation du capteur C1, dans laquelle la microlentille 124 est remplacée par une couche nanostructurée 124'. La couche 124' est par exemple constituée de plots de silicium polycristallin (en noir sur la figure) de dimensions nanométriques, séparés les uns des autres par un matériau de remplissage (en blanc sur la figure) d'indice optique inférieur, par exemple de l'oxyde de silicium. A titre d'exemple, les dimensions des nanostructurations de la couche 124' sont telles que la couche 124' satisfasse aux conditions d'antireflet quart d'onde à la longueur d'onde λC2 d'utilisation du capteur C2, c'est-à-dire telles que l'épaisseur e de la couche soit de l'ordre de e=λC2/(4*n_eff), n_eff désignant l'indice effectif de la couche 124'. A titre d'exemple, les plots de silicium polycristallin ont des dimensions latérales de l'ordre de 100 à 150 nm et sont espacés deux à deux d'environ 100 à 200 nm. L'indice effectif n eff de la couche 124' est alors de l'ordre de 2,3 (dans le cas où le matériau de remplissage est de l'oxyde de silicium), et l'épaisseur e de la couche 124' peut être choisie de l'ordre de 100 nm pour satisfaire aux conditions d'antireflet quart d'onde pour une longueur d'onde λC2 de l'ordre de 940 nm. Dans l'exemple représenté, la couche 124' est disposée dans une partie inférieure de l'empilement d'interconnexion 110. A titre d'exemple, la couche 124' est formée dans un niveau de silicium polycristallin dans lequel sont formées les grilles de transistors MOS en technologie CMOS.

La figure 2ter illustre une autre variante de réalisation du capteur C1, pas compris dans la présente invention, dans laquelle la microlentille 124 est remplacée par un empilement multicouches 124" formant un dispositif antireflet à la longueur d'onde λC2 d'utilisation du capteur C2. Dans l'exemple représenté, l'empilement 124" est disposé dans une partie inférieure de l'empilement d'interconnexion 110. A titre d'exemple, l'empilement 124' peut être un empilement nitrure - oxyde - nitrure dans lequel les épaisseurs des couches de nitrure et de la couche d'oxyde sont optimisées pour remplir la fonction antireflet recherchée. Bien que l'empilement 124" ait été représenté de façon localisée sur la figure 2ter, en pratique l'empilement 124" peut s'étendre sur sensiblement toute la surface du capteur C1.

Dans l'invention, non représentée, la microlentille 124 de la figure 2 est prévue en combinaison avec la couche nanostrcturée 124' de la figure 2bis .

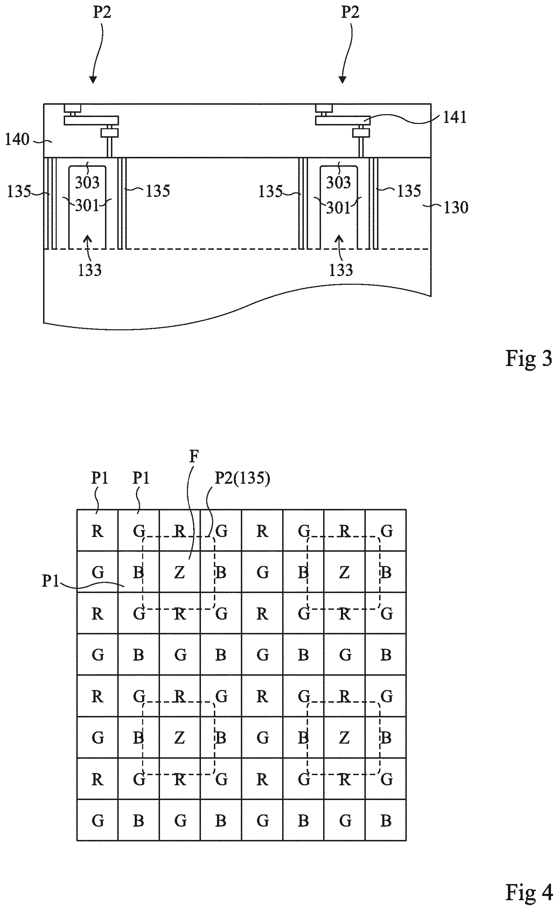

La figure 3 est une vue en coupe illustrant plus en détail un exemple de réalisation du capteur d'image de profondeur C2 du dispositif de la figure 1.

Pour réaliser ce capteur, on part d'un substrat semiconducteur 130 relativement épais, par exemple de plusieurs centaines de micromètres d'épaisseur.

Les photodiodes de type SPAD 133 ainsi que d'éventuels composants de contrôle des pixels P2 du capteur sont formés à partir d'une première face du substrat 130, à savoir sa face supérieure dans l'orientation de la figure 3. Les murs d'isolation verticaux 135 délimitant, en vue de dessus, les zones de détection des pixels P2 du capteur, sont en outre formés depuis la face supérieure du substrat 130.

Dans l'exemple représenté, chaque photodiode SPAD 133 comprend une première région semiconductrice verticale 301 de type de conductivité opposé à celui du substrat 130, s'étendant dans le substrat 130 depuis sa face supérieure et en direction de sa face inférieure, les faces latérales de la région 301 étant en contact avec le substrat 130 et la jonction entre les faces latérales de la région 301 et le substrat 130 définissant une zone d'avalanche de la photodiode. A titre d'exemple, la région 301 a la forme d'un tube d'axe central sensiblement vertical.

Chaque photodiode SPAD 133 peut en outre comprendre une deuxième région semiconductrice horizontale 303 de même type de conductivité que la région 301, disposée du côté de la face supérieure du substrat 130, la face supérieure de la région verticale 301 étant en contact avec la face inférieure de la région horizontale 303. A titre d'exemple, la région 303 a la forme d'un couvercle sensiblement horizontal fermant l'extrémité supérieure de la région tubulaire 301.

La région semiconductrice horizontale 303 peut avoir un niveau de dopage inférieur à celui de la région semiconductrice verticale 301, ou un niveau de dopage sensiblement égal à celui de la région semiconductrice verticale 301.

Les avantages d'une telle structure de photodiode SPAD sont décrits dans les demandes de brevet français N°16/58513 et PCT N°PCT/FR2017/052406 susmentionnées.

Après la réalisation des photodiodes SPAD 133 et des murs d'isolation verticaux 135, l'empilement d'interconnexion 140 du capteur C2 est formé sur la face supérieure du substrat 130.

La réalisation du dispositif de la figure 1 peut comprendre les étapes suivantes :
- réalisation du circuit de contrôle et de traitement C3 ;
- réalisation partielle du capteur C2 selon les étapes décrites en relation avec la figure 3 ;
- retournement du capteur C2 de la figure 3 et collage hybride (métal-métal/oxyde-oxyde) de la face supérieure (dans l'orientation de la figure 3) du capteur C2 à la face supérieure (dans l'orientation de la figure 1) du circuit C3 ;

- amincissement du substrat 130 du capteur C2 en utilisant le circuit C3 comme poignée ;
- réalisation éventuelle d'un filtre passe bande adapté à laisser passer de façon préférentielle la gamme de longueurs d'ondes d'émission de la source lumineuse utilisée pour réaliser la mesure de distance ;
- réalisation éventuelle de l'écran métallique 137 sur la face supérieure (dans l'orientation de la figure 1) du substrat 130 aminci ;
- réalisation partielle du capteur C1 selon les étapes décrites en relation avec la figure 2 ;
- retournement du capteur C1 de la figure 2 et collage de la face supérieure (dans l'orientation de la figure 2) du capteur C1 à la face supérieure (dans l'orientation de la figure 1) du substrat 130 aminci, sans contact électrique entre les capteurs C1 et C2 ;
- amincissement du substrat 100 du capteur C1 en utilisant le circuit C3 et le capteur C2 comme poignée de maintien ; et
- réalisation des éléments supérieurs du capteur C1 (couche de passivation 115, filtres 118 et 120 et microlentilles 122 en particulier) sur la face supérieure du substrat 100 aminci.

La figure 4 est une vue de dessus schématique du dispositif de la figure 1, représentant un exemple d'agencement des pixels 2D P1 et des pixels de profondeur P2 dans le dispositif de la figure 1.

Dans cet exemple, le capteur C1 est un capteur couleur comprenant trois types de pixels P1 distincts, à savoir des pixels rouges (R), des pixels bleus (B) et des pixels verts (G). Les pixels P1 sont répartis en matrice selon des rangées et des colonnes, par exemple selon un motif de Bayer. De façon périodique, un pixel P1 de la matrice est remplacé par une fenêtre F (un pixel sur 4 dans la direction des rangées et un pixel sur 4 dans la direction des colonnes dans l'exemple représenté) surmontant un pixel P2 du capteur C2. Le mur d'isolation vertical 135 délimitant la zone de détection de chaque pixel P2 a été représenté en pointillés sur la figure 4. Dans cet exemple, en vue de dessus, les dimensions des zones de détection des pixels P2 du capteur C2 sont supérieures aux dimensions des fenêtres F du capteur C1. Ceci permet de faciliter l'alignement du capteur C1 par rapport au capteur C2 lors de la réalisation du dispositif.

Dans le dispositif de la figure 1, les pixels P2 de profondeur peuvent être commandés individuellement de façon à produire une image de profondeur de résolution égale au nombre de pixels P2 du capteur C2.

A titre de variante, les pixels P2 peuvent être couplés par blocs de plusieurs pixels voisins, par exemple des blocs de trois par trois pixels P2 voisins de façon à réaliser un photo-multiplieur, par exemple de type SIPM. On prévoit alors de ne retenir que les évènements corrélés au sein de chaque bloc. Autrement dit, seuls les évènements détectés simultanément par plusieurs pixels du bloc seront retenus pour construire l'image de profondeur. La résolution de l'image de profondeur est alors inférieure au nombre de pixels P2 du capteur C2, mais l'immunité au bruit du capteur d'image de profondeur s'en trouve améliorée.

On notera que selon l'application considérée, la cadence d'acquisition des images 2D par le capteur C1 peut être différente de la cadence d'acquisition des images de profondeur par le capteur C2.

Des modes de réalisation particuliers ont été décrits. Diverses variantes et modifications apparaîtront à l'homme de l'art. En particulier, on a décrit des exemples de réalisation dans lesquels le collage entre les capteurs C1 et C2 est un collage moléculaire d'une couche d'oxyde 126 du capteur C1 sur une couche d'oxyde 132 du capteur C2. Les modes de réalisation ne se limitent toutefois pas à ce cas particulier. A titre de variante, les couches 126 et 132 peuvent être des couches métalliques, le collage réalisé étant alors un collage moléculaire métal-métal. Dans ce cas, les couches métalliques 126 et 132 peuvent comprendre des ouvertures en vis-à-vis des fenêtres F du capteur C1. L'empilement des couches 126 et 132 forme alors un écran métallique revêtant sensiblement toute la face avant du substrat 130 du capteur C2 à l'exception des zones de détection des pixels P2, cet écran pouvant remplacer l'écran 137 de la figure 1.

Par ailleurs, on a décrit ci-dessus des exemples de réalisation dans lesquels chaque pixel de profondeur P2 du capteur C2 comprend une photodiode de type SPAD. Les modes de réalisation décrits ne se limitent toutefois pas à ce cas particulier. A titre de variante, le pixel de profondeur peut être réalisé dans toute autre technologie adaptée à la mise en oeuvre d'une mesure de temps de vol d'un signal lumineux émis par une source lumineuse et réfléchi par la scène. A titre d'exemple, le pixel de profondeur peut être un pixel de type lock-in, tel que décrit dans les demandes de brevet français N°16/62341 (DD17552/B15537) et N°16/62340 (DD17326/B15344) précédemment déposées par la demanderesse, c'est-à-dire un pixel comprenant plusieurs zones mémoire couplées à une même zone de détection, et permettant de mesurer un déphasage entre un signal lumineux modulé en amplitude, émis par la source lumineuse, et un signal lumineux reçu par la zone de photodétection du pixel, après réflexion sur la scène.

En outre, on a décrit ci-dessus des exemples de réalisation dans lesquels les fenêtres transmissives F formées dans le capteur C1 ne comprennent pas de composant actif. Les modes de réalisation décrits ne se limitent toutefois pas à ce cas particulier. A titre de variante, on pourra prévoir de disposer, dans chaque fenêtre F du capteur C1, un pixel actif, par exemple un pixel infrarouge, ou un pixel visible.

A titre d'exemple, on peut prévoir d'inclure dans chaque fenêtre F un pixel infrarouge. Les pixels infrarouges prévus dans les fenêtres transmissives F permettent par exemple de réaliser des mesures de profondeur au moyen d'une source lumineuse appliquant un éclairage structuré sur la scène. A titre d'exemple, la mesure de profondeur utilisant la lumière structurée et les pixels infrarouges du capteur C1, peut être utilisée pour mesurer des distances relativement faibles, par exemple inférieures à 5 mètres, tandis que la mesure de profondeur par mesure de temps de vol, utilisant les pixels P2 du capteur C2, peut être utilisée pour mesurer des distances relativement élevées, par exemple supérieures à 5 mètres.

## Revendications

1. Dispositif d'acquisition d'une image 2D et d'une image de profondeur, comprenant :
un premier capteur (C1) comportant une face avant et une face arrière, le premier capteur étant formé dans et sur un premier substrat semiconducteur (100) et comprenant une pluralité de pixels d'image 2D (P1) et une pluralité de fenêtres transmissives (F) comprenant chacune une portion du premier substrat semiconducteur (100) ; et
un deuxième capteur (C2) comportant une face avant accolée à la face arrière du premier capteur et une face arrière opposée au premier capteur, le deuxième capteur étant formé dans et sur un deuxième substrat semiconducteur (130) et comprenant une pluralité de pixels de profondeur (P2) disposés en regard des fenêtres du premier capteur,
dans lequel chaque fenêtre transmissive (F) du premier capteur (C1) comprend, entre la face arrière du premier substrat semiconducteur (100) et le deuxième capteur (C2), un élément optique (124 ; 124' ; 124") adapté à favoriser le transfert de la lumière incidente du premier capteur (C1) vers les pixels de profondeur (P2) du deuxième capteur (C2),
**caractérisé en ce que** ledit élément optique comprend :
- une microlentille (124) ; et/ou
- une couche nanostructurée (124') présentant des nanostructurations de dimensions telles que ladite couche (124') satisfasse aux conditions d'antireflet quart d'onde à la longueur d'onde λC2 d'utilisation du capteur C2, c'est-à-dire telles que l'épaisseur e de la couche soit de l'ordre de e=λC2/(4*n_eff), n_eff désignant l'indice effectif de la couche 124'.

2. Dispositif selon la revendication 1, dans lequel chaque fenêtre transmissive (F) du premier capteur (C1) comprend un pixel actif.

3. Dispositif selon la revendication 1 ou 2, dans lequel le deuxième capteur (C2) comprend en outre un écran métallique (137) revêtant sensiblement toute la face avant du deuxième substrat semiconducteur (130), à l'exception des portions du deuxième substrat (130) situées en vis-à-vis des fenêtres transmissives (F) du premier capteur (C1).

4. Dispositif selon l'une quelconque des revendications 1 à 3, dans lequel chaque pixel de profondeur comprend une photodiode de type SPAD (133).

5. Dispositif selon l'une quelconque des revendications 1 à 3, dans lequel chaque pixel de profondeur comprend plusieurs zones mémoire couplées à une même zone de détection, et permet de mesurer un déphasage entre un signal lumineux modulé en amplitude, émis par une source lumineuse du dispositif, et un signal lumineux reçu par la zone de photodétection du pixel, après réflexion sur une scène dont on souhaite acquérir une image.

6. Dispositif selon l'une quelconque des revendications 1 à 5, dans lequel le deuxième capteur (C2) comprend un empilement d'interconnexion (140) dans lequel sont formées des pistes et/ou bornes de connexion électrique (141) connectant les pixels de profondeur (P2) du deuxième capteur à un circuit périphérique de commande et d'alimentation du deuxième capteur, ledit empilement d'interconnexion (140) étant disposé du côté de la face arrière du deuxième substrat semiconducteur (130).

7. Dispositif selon l'une quelconque des revendications 1 à 6, dans lequel le premier capteur (C1) comprend un empilement d'interconnexion (110) dans lequel sont formées des pistes et/ou bornes de connexion électrique (111) connectant les pixels d'image 2D (P1) du premier capteur à un circuit périphérique de commande et d'alimentation du premier capteur, ledit empilement d'interconnexion (110) étant disposé du côté de la face arrière du premier substrat semiconducteur (100).

8. Dispositif selon la revendication 7, dans lequel l'empilement d'interconnexion (110) du premier capteur (C1) ne comprend pas de métallisations dans les fenêtres transmissives (F) du premier capteur (C1).

9. Dispositif selon l'une quelconque des revendications 1 à 8, dans lequel chaque pixel d'image 2D (P1) du premier capteur comprend une photodiode (101).

10. Dispositif selon l'une quelconque des revendications 1 à 9, dans lequel, dans chaque pixel de profondeur (P2) du deuxième capteur (C2), une zone de photodétection du pixel est entourée par un mur d'isolation vertical (135) s'étendant sur toute l'épaisseur du deuxième substrat (130).

11. Dispositif selon la revendication 10, dans lequel, en vue de dessus, la surface de chaque pixel de profondeur (P2) entourée par le mur d'isolation vertical (135) est supérieure à la surface de la fenêtre transmissive (F) correspondante du premier capteur.

12. Dispositif selon l'une quelconque des revendications 1 à 11, dans lequel chaque fenêtre transmissive (F) du premier capteur (C1) comprend un filtre optique passe-bande (120) adapté à transmettre la lumière uniquement dans une bande de largeur à mi-hauteur inférieure à 30 nm.

13. Dispositif selon la revendication 12, dans lequel le filtre optique passe-bande (120) est disposé entre le premier substrat (100) et le deuxième substrat (130) et s'étend de façon continue sur sensiblement toute la surface du dispositif.

14. Dispositif selon l'une quelconque des revendications 1 à 13, comportant en outre un circuit de contrôle et de traitement (C3) formé dans et sur un troisième substrat semiconducteur (160), ledit circuit de contrôle et de traitement (C3) étant accolé à la face arrière du deuxième capteur (C2).

15. Dispositif selon l'une quelconque des revendications 1 à 14, dans lequel le circuit de contrôle et de traitement (C3) est fixé à la face arrière du deuxième capteur (C2) par collage moléculaire hybride.

16. Dispositif selon l'une quelconque des revendications 1 à 15, dans lequel les premier (100) et deuxième (130) substrats semiconducteurs sont en silicium monocristallin.

17. Dispositif selon l'une quelconque des revendications 1 à 16, dans lequel les premier (C1) et deuxième (C2) capteurs sont fixés par collage moléculaire.

18. Dispositif selon l'une quelconque des revendications 1 à 17, dans lequel les pixels de profondeur (P2) sont couplés par blocs de plusieurs pixels voisins de façon à réaliser un photo-multiplieur.

## Patentansprüche

1. Vorrichtung zur Erfassung eines 2D-Bildes und eines Tiefenbildes, wobei die Vorrichtung Folgendes aufweist:
einen ersten Sensor (C1) mit einer vorderen Oberfläche bzw. Vorderseite und einer hinteren Oberfläche bzw. Rückseite, wobei der erste Sensor innerhalb und auf einem ersten Halbleitersubstrat (100) ausgebildet ist und eine Vielzahl von 2D-Bildpixeln (P1) und eine Vielzahl von durchlässigen bzw. transmissiven Fenstern (F) aufweist, die jeweils einen Teil des ersten Halbleitersubstrats (100) aufweisen; und
einen zweiten Sensor (C2), der eine vordere Oberfläche, die gegen die hintere Oberfläche des ersten Sensors angeordnet ist, und eine hintere Oberfläche gegenüber dem ersten Sensor aufweist, wobei der zweite Sensor innerhalb und auf der Oberseite eines zweiten Halbleitersubstrats (130) ausgebildet ist und eine Vielzahl von Tiefenpixeln (P2) aufweist, die gegenüber den Fenstern des ersten Sensors angeordnet sind,
wobei jedes durchlässige Fenster (F) des ersten Sensors (C1) zwischen der Rückseite des ersten Halbleitersubstrats (100) und dem zweiten Sensor (C2) ein optisches Element (124; 124'; 124") aufweist, das in der Lage ist, die Übertragung des einfallenden Lichts von dem ersten Sensor (C1) zu den Tiefenpixeln (P2) des zweiten Sensors (C2) zu begünstigen,
**dadurch gekennzeichnet, dass** das optische Element aufweist:
- eine Mikrolinse (124); und/oder
- eine nanostrukturierte Schicht (124') mit Nanostrukturen, die solche Abmessungen haben, dass die Schicht (124') die Bedingungen für die Antireflexion der Viertelwellen bei der Wellenlänge AC2 der Verwendung des Sensors C2 erfüllt, d.h. dass die Dicke e der Schicht in der Größenordnung von e=λC2/(4*n_eff) liegt, wobei n_eff den effektiven Index der Schicht 124' bezeichnet.

2. Vorrichtung nach Anspruch 1, wobei jedes transmissive Fenster (F) des ersten Sensors (C1) ein aktives Pixel aufweist.

3. Vorrichtung nach Anspruch 1 oder 2, wobei der zweite Sensor (C2) ferner eine Metallabschirmung (137) aufweist, die im Wesentlichen die gesamte vordere Oberfläche des zweiten Halbleitersubstrats (130) bedeckt, mit Ausnahme der Abschnitte des zweiten Substrats (130), die den durchlässigen Fenstern (F) des ersten Sensors (C1) gegenüberliegen.

4. Vorrichtung nach einem der Ansprüche 1 bis 3, wobei jedes Tiefenpixel eine Fotodiode vom SPAD-Typ (133) aufweist.

5. Vorrichtung nach einem der Ansprüche 1 bis 3, wobei jedes Tiefenpixel eine Vielzahl von Speicherbereichen aufweist, die mit demselben Erfassungsbereich gekoppelt sind, und es ermöglicht, eine Phasenverschiebung zwischen einem amplitudenmodulierten Lichtsignal, das von einer Lichtquelle der Vorrichtung emittiert wird, und einem Lichtsignal, das von dem Pixel-Fotodetektionsbereich empfangen wird, nach Reflexion an einer Szene, von der ein Bild erfasst werden soll, zu messen.

6. Vorrichtung nach einem der Ansprüche 1 bis 5, wobei der zweite Sensor (C2) einen Verbindungsstapel (140) mit elektrischen Verbindungsspuren und/oder Anschlüssen (141) aufweist, die die Tiefenpixel (P2) des zweiten Sensors mit einer darin ausgebildeten peripheren Steuer- und Stromversorgungsschaltung des zweiten Sensors verbinden, wobei der Verbindungsstapel (140) auf der Rückseite des zweiten Halbleitersubstrats (130) angeordnet ist.

7. Vorrichtung nach einem der Ansprüche 1 bis 6, wobei der erste Sensor (C1) einen Verbindungsstapel (110) mit elektrischen Verbindungsspuren und/oder Anschlüssen (111) aufweist, die die 2D-Bildpixel (P1) des ersten Sensors mit einer darin ausgebildeten peripheren Steuer- und Stromversorgungsschaltung des ersten Sensors verbinden, wobei der Verbindungsstapel (110) auf der Rückseite des ersten Halbleitersubstrats (100) angeordnet ist.

8. Vorrichtung nach Anspruch 7, wobei der Verbindungsstapel (110) des ersten Sensors (C1) keine Metallisierungen in den transmissiven Fenstern (F) des ersten Sensors (C1) aufweist.

9. Vorrichtung nach einem der Ansprüche 1 bis 8, wobei jedes 2D-Bildpixel (P1) des ersten Sensors eine Fotodiode (101) aufweist.

10. Vorrichtung nach einem der Ansprüche 1 bis 9, wobei in jedem Tiefenpixel (P2) des zweiten Sensors (C2) ein Fotodetektionsbereich des Pixels von einer vertikalen Isolierwand (135) umgeben ist, die sich über die gesamte Dicke des zweiten Substrats (130) erstreckt.

11. Vorrichtung nach Anspruch 10, wobei in der Draufsicht der Oberflächenbereich jedes Tiefenpixels (P2), das von der vertikalen Isolierwand (135) umgeben ist, größer ist als der Oberflächenbereich des entsprechenden durchlässigen Fensters (F) des ersten Sensors.

12. Vorrichtung nach einem der Ansprüche 1 bis 11, wobei jedes durchlässige Fenster (F) des ersten Sensors (C1) ein optisches Bandpassfilter (120) aufweist, das in der Lage ist, Licht nur in einer Bandbreite bei halbem Maximum von weniger als 30 nm durchzulassen.

13. Vorrichtung nach einem der Ansprüche 1 bis 11, wobei der optische Bandpassfilter (120) zwischen dem ersten Substrat (100) und dem zweiten Substrat (130) angeordnet ist und sich kontinuierlich über im Wesentlichen die gesamte Oberfläche der Vorrichtung erstreckt.

14. Vorrichtung nach einem der Ansprüche 1 bis 13, die ferner eine Steuer- und Verarbeitungsschaltung (C3) aufweist, die innerhalb und auf der Oberseite eines dritten Halbleitersubstrats (160) ausgebildet ist, wobei die Steuer- und Verarbeitungsschaltung (C3) an der Rückseite des zweiten Sensors (C2) angeordnet ist.

15. Vorrichtung nach einem der Ansprüche 1 bis 14, wobei die Steuer- und Verarbeitungsschaltung (C3) an der Rückseite des zweiten Sensors (C2) durch hybride molekulare Bindung angebracht ist.

16. Optoelektronische Vorrichtung nach einem der Ansprüche 1 bis 15, wobei das erste (100) und das zweite (130) Halbleitersubstrat aus einkristallinem Silizium hergestellt sind.

17. Vorrichtung nach einem der Ansprüche 1 bis 16, wobei der erste (C1) und der zweite (C2) Sensor durch molekulares Bonden befestigt sind.

18. Vorrichtung nach einem der Ansprüche 1 bis 17, wobei die Tiefenpixel (P2) durch Blöcke aus einer Vielzahl benachbarter Pixel gekoppelt sind, um einen Photovervielfacher zu bilden.

## Claims

1. A device of acquisition of a 2D image and of a depth image, comprising:
a first sensor (C1) comprising a front surface and a rear surface, the first sensor being formed inside and on top of a first semiconductor substrate (100) and comprising a plurality of 2D image pixels (P1) and a plurality of transmissive windows (F) each comprising a portion of the first semiconductor substrate (100); and
a second sensor (C2) comprising a front surface placed against the rear surface of the first sensor and a rear surface opposite to the first sensor, the second sensor being formed inside and on top of a second semiconductor substrate (130) and comprising a plurality of depth pixels (P2) arranged opposite the windows of the first sensor,
wherein each transmissive window (F) of the first sensor (C1) comprises, between the rear surface of the first semiconductor substrate (100) and the second sensor (C2), an optical element (124; 124'; 124") capable of favoring the transfer of the incident light from the first sensor (C1) to the depth pixels (P2) of the second sensor (C2),
**characterized in that** said optical element comprises:
- a microlens (124) ; and/or
- a nanostructured layer (124') having nanostructurations having dimensions such that said layer (124') fulfills the quarter wave antireflection conditions at wavelength λC2 of use of sensor C2, that is, such that thickness e of the layer is in the order of e=λC2/(4*n_eff), n_eff designating the effective index of layer 124'.

2. The device of claim 1, wherein each transmissive window (F) of the first sensor (C1) comprises an active pixel.

3. The device of claim 1 or 2, wherein the second sensor (C2) further comprises a metal shield (137) substantially coating the entire front surface of the second semiconductor substrate (130), except for the portions of the second substrate (130) located opposite the transmissive windows (F) of the first sensor (C1).

4. The device of any of claims 1 to 3, wherein each depth pixel comprises a SPAD-type photodiode (133).

5. The device of any of claims 1 to 3, wherein each depth pixel comprises a plurality of memory areas coupled to a same detection area, and enables to measure a phase shift between an amplitude-modulated light signal, emitted by a light source of the device, and a light signal received by the pixel photodetection area, after reflection on a scene an image of which is desired to be acquired.

6. The device of any of claims 1 to 5, wherein the second sensor (C2) comprises an interconnection stack (140) having electric connection tracks and/or terminals (141) connecting the depth pixels (P2) of the second sensor to a peripheral control and power supply circuit of the second sensor formed therein, said interconnection stack (140) being arranged on the rear surface side of the second semiconductor substrate (130).

7. The device of any of claims 1 to 6, wherein the first sensor (C1) comprises an interconnection stack (110) having electric connection tracks and/or terminals (111) connecting the 2D image pixels (P1) of the first sensor to a peripheral control and power supply circuit of the first sensor formed therein, said interconnection stack (110) being arranged on the rear surface side of the first semiconductor substrate (100).

8. The device of claim 7, wherein the interconnection stack (110) of the first sensor (C1) comprises no metallizations in the transmissive windows (F) of the first sensor (C1).

9. The device of any of claims 1 to 8, wherein each 2D image pixel (P1) of the first sensor comprises a photodiode (101) .

10. The device of any of claims 1 to 9, wherein, in each depth pixel (P2) of the second sensor (C2), a photodetec-tion area of the pixel is surrounded with a vertical insulating wall (135) extending across the entire thickness of the second substrate (130).

11. The device of claim 10, wherein, in top view, the surface area of each depth pixel (P2) surrounded with the vertical insulating wall (135) is greater than the surface area of the corresponding transmissive window (F) of the first sensor.

12. The device of any of claims 1 to 11, wherein each transmissive window (F) of the first sensor (C1) comprises an optical bandpass filter (120) capable of transmitting light only in a bandwidth at half maximum smaller than 30 nm.

13. The device of any of claims 1 to 11, wherein the optical bandpass filter (120) is disposed between the first substrate (100) and the second substrate (130) and extends continuously over substantially the entire surface of the device.

14. The device of any of claims 1 to 13, further comprising a control and processing circuit (C3) formed inside and on top of a third semiconductor substrate (160), said control and processing circuit (C3) being placed against the rear surface of the second sensor (C2).

15. The device of any of claims 1 to 14, wherein the control and processing circuit (C3) is attached to the rear surface of the second sensor (C2) by hybrid molecular bonding.

16. The optoelectronic device of any of claims 1 to 15, wherein the first (100) and second (130) semiconductor substrates are made of single-crystal silicon.

17. The device of any of claims 1 to 16, wherein the first (C1) and second (C2) sensors are attached by molecular bonding.

18. The device of any of claims 1 to 17, wherein the depth pixels (P2) are coupled by blocks of a plurality of neighboring pixels to form a photomultiplier.
